# EUROPEAN PATENT APPLICATION

(11) **EP 4 730 398 A1**
(43) Date of publication of application: **22.04.2026**
(21) Application number: 24825027.6
(22) Date of filing: 10.05.2024
(51) Int. Cl.: H01L 25/075, H01L 27/15

(54) **PIXEL UNIT AND MANUFACTURING METHOD THEREFOR, MICRO DISPLAY SCREEN, AND PIXEL-LEVEL DISCRETE DEVICE**

(30) Priority: 21.06.2023 CN 202310742884
(71) Applicant: Innovision Technology (Suzhou) Co., Ltd, Suzhou, Jiangsu 215000 (CN)
(72) Inventor: YANG, Zhixiang, Suzhou, Jiangsu 215000 (CN); WANG, Yazhou, Suzhou, Jiangsu 215000 (CN); SHAO, Mingjing, Suzhou, Jiangsu 215000 (CN)
(74) Representative: Winter, Brandl - Partnerschaft mbB
(86) International application number: PCT/CN2024/092234
(87) International publication number: WO 2024/260130

(57) **Abstract**

This application discloses a pixel unit and a fabricating method thereof, a microdisplay, and a pixel-level discrete device. The pixel unit includes a drive backplane and a display unit; the display unit is disposed on the drive backplane, the display unit includes a first device layer, a second device layer, and a third device layer that are sequentially vertically stacked, the first device layer includes at least one first sub-pixel, the second device layer includes at least one second sub-pixel, the third device layer includes at least one third sub-pixel, and a projection of any first sub-pixel, any second sub-pixel, or any third sub-pixel on the drive backplane is located within a projection of any sub-pixel above the first sub-pixel, the second sub-pixel, or the third sub-pixel on the drive backplane; and the first device layer emits red light in a working state, the second device layer emits green light in a working state, and the third device layer emits blue light in a working state. The pixel unit in this application effectively improves a pixel density through a vertically coaxially stacked manner, and volumes of sub-pixels in different device layers can be adjusted to satisfy different color configuration requirements.

## Description

This application claims priority to Chinese Patent Application No. 202310742884.7, entitled "PIXEL UNIT AND FABRICATING METHOD THEREOF, MICRODISPLAY, AND PIXEL-LEVEL DISCRETE DEVICE" filed on June 21, 2023, which is incorporated herein by reference in its entirety.

### TECHNICAL FIELD

This application relates to the field of semiconductor device technologies, and in particular, to a pixel unit and a fabricating method thereof, a microdisplay, and a pixel-level discrete device.

### BACKGROUND

The Micro-LED display technology is generally considered as a next-generation display technology, and has great promise in both wearable devices and direct display fields. Currently, colorization display remains a very challenging issue. Currently, the Micro-LED is mainly classified into vertical non-coaxial stack and vertical coaxial stack.

In a vertically non-coaxially stacked Micro-LED, anode electrical connection needs to be performed from a side wall, and a metal bonding material is usually required for bonding between device layers. Therefore, a compound at the base of an upper pixel does not participate in photoelectric conversion at all, resulting in a significant sacrifice of space. In addition, the electrical connection of the side wall is restricted by a material encapsulation capability, and process realization is difficult. Most importantly, a pixel density of a pixel unit of the vertically non-coaxially stacked Micro-LED is low.

In comparison, a vertically coaxially stacked Micro-LED enables a higher pixel density. In a pixel unit of the existing vertically coaxially stacked Micro-LED, sub-pixels of different device layers are gradually reduced from bottom to top, which is not beneficial to adjusting pixel dimensions based on a requirement for color configuration. The reason why the sub-pixels are gradually reduced from bottom to top is that in the existing pixel stack process, a process such as first stacking all compound semiconductor layers, and then etching from top to bottom is used to perform structure construction such as expose and electrical connection. Consequently, a structure in which a volume of a sub-pixel at a topmost layer is smallest, and a volume of a sub-pixel at a lowermost layer is largest is formed.

Therefore, it is urgent to find a pixel unit that can effectively overcome the foregoing defect.

### SUMMARY

The objective of this application is to provide a pixel unit and a fabricating method thereof, a microdisplay, and a pixel-level discrete device. The pixel unit can flexibly adjust sub-pixel dimensions based on improving a pixel density, thereby meeting diverse color configuration requirements.

To achieve the foregoing objective, a first aspect of this application provides a pixel unit, where the pixel unit includes:
a drive backplane; and
a display unit, the display unit being disposed on the drive backplane, the display unit including a first device layer, a second device layer, and a third device layer that are sequentially vertically stacked along a direction away from the drive backplane, the first device layer including at least one first sub-pixel, the second device layer including at least one second sub-pixel, the third device layer including at least one third sub-pixel, and a projection of any first sub-pixel, any second sub-pixel, or any third sub-pixel on the drive backplane being located within a projection of any sub-pixel above the first sub-pixel, the second sub-pixel, or the third sub-pixel on the drive backplane; and
the first device layer emits red light in a working state, the second device layer emits green light in a working state, and the third device layer emits blue light in a working state.

In a preferred implementation, a central point of any one of the first sub-pixel, the second sub-pixel, and the third sub-pixel is located on a same vertical line of the drive backplane.

In a preferred implementation, the first device layer further includes a first fill layer that encapsulates any first sub-pixel, a transmittance of the first fill layer for visible light in a band from 600 nm to 650 nm is not less than 90%, and a reflectivity of the first fill layer for visible light in a band from 500 nm to 550 nm is not less than 90%;
the second device layer further includes a second fill layer that encapsulates any second sub-pixel, a transmittance of the second fill layer for visible light in a band from 600 nm to 650 nm and a band from 500 nm to 550 nm is not less than 90%, and a reflectivity of the second fill layer for visible light in a band from 400 nm to 460 nm is not less than 90%; and
the third device layer further includes a third fill layer that encapsulates any third sub-pixel, and a transmittance of the third fill layer for visible light in a band from 600 nm to 650 nm, a band from 500 nm to 550 nm, and a band from 400 nm to 460 nm is not less than 90%.

In a preferred implementation, the second device layer further includes a second passivation layer and a second ohmic layer;
the second passivation layer is covered on a surface of any second sub-pixel; and
the second ohmic layer is covered on a surface of the second passivation layer, and the second ohmic layer is connected to any second sub-pixel through the second passivation layer.

In a preferred implementation, the drive backplane includes at least three anodes, the first device layer further includes at least three anode fill layers, and any anode fill layer is connected to any corresponding anode; and
at least one point of any anode fill layer in the at least three anode fill layers is located on a same straight line of the drive backplane.

In a preferred implementation, the second device layer further includes at least two first bus layers, and any first bus layer is located above any anode fill layer; and
the first device layer further includes at least one anode electrical connection structure, and one end of any anode electrical connection structure in the first device layer is connected to the anode fill layer, and the other end is connected to a corresponding first bus layer.

In a preferred implementation, any first sub-pixel is connected to a corresponding anode fill layer; or
the first device layer further includes at least one first conductive layer, a side of any first conductive layer away from the drive backplane is connected to any first sub-pixel, and a side close to the drive backplane is connected to a corresponding anode fill layer.

In a preferred implementation, when any one of the first sub-pixel, the second sub-pixel, and the third sub-pixel is one of a hemisphere, a semi-ellipsoid, or a cylinder with a hemispherical light-emitting surface, and all sub-pixels are equal in volume, a projection of any sub-pixel on the drive backplane does not coincide with a projection of any anode electrical connection structure on the drive backplane.

In a preferred implementation, the second device layer further includes at least one second conductive layer, and a projection of the second conductive layer on the drive backplane is greater than a projection of the second sub-pixel on the drive backplane; and
one side of any second conductive layer is connected to any second sub-pixel, and the other side is connected to a corresponding first bus layer.

In a preferred implementation, when any one of the first sub-pixel, the second sub-pixel, and the third sub-pixel is a cuboid, any anode electrical connection structure in the first device layer is embedded in a corresponding first sub-pixel, and a projection, on the drive backplane, of any anode electrical connection structure in the first device layer is located within a projection of any third sub-pixel on the drive backplane.

In a preferred implementation, any one of the first device layer, the second device layer, and the third device layer further includes a color conversion layer disposed above any sub-pixel, and the color conversion layer absorbs an excitation light source emitted by a corresponding sub-pixel and converts the excitation light source into a target light source.

In a preferred implementation, the display unit further includes at least one reinforcement structure disposed on a periphery of any device layer.

According to a second aspect, a fabricating method for a pixel unit is provided, where the fabricating method includes:
preparing a drive backplane; and
fabricating a display unit, bonding a first target compound semiconductor to the drive backplane, and constructing at least one first sub-pixel to form a first device layer; bonding a second target compound semiconductor to the first device layer and constructing at least one second sub-pixel to form a second device layer; bonding a third target compound semiconductor to the second device layer and constructing at least one third sub-pixel to form a third device layer; and a projection of any first sub-pixel, any second sub-pixel, or any third sub-pixel on the drive backplane is located within a projection of any sub-pixel above the first sub-pixel, the second sub-pixel, or the third sub-pixel on the drive backplane; and
the first device layer emits red light in a working state, the second device layer emits green light in a working state, and the third device layer emits blue light in a working state.

According to a third aspect, a microdisplay is provided, where the microdisplay includes:
a microdisplay backplane, the microdisplay backplane including a drive circuit, an input interface, and an output interface;
a display area, the display area being disposed on the microdisplay backplane, the display area including at least two display units included in the pixel unit according to any one of the first aspect, and the at least two display units being arranged in an array; and
a peripheral common cathode, the peripheral common cathode being electrically connected to each display unit.

According to a fourth aspect, a pixel-level discrete device is provided, where the pixel-level discrete device includes:
a discrete device backplane, the discrete device backplane including at least two anode pads and at least one cathode pad; and
a device body, the device body being disposed on the discrete device backplane, the device body including at least two display units included in the pixel unit according to any one of the first aspect, and the at least two display units being arranged in an array.

Compared with the existing technology, this application has the following beneficial effects.

This application provides a pixel unit and a fabricating method thereof, a microdisplay, and a pixel-level discrete device. The pixel unit includes a drive backplane and a display unit; the display unit is disposed on the drive backplane, the display unit includes a first device layer, a second device layer, and a third device layer that are sequentially vertically stacked along a direction away from the drive backplane, the first device layer includes at least one first sub-pixel, the second device layer includes at least one second sub-pixel, the third device layer includes at least one third sub-pixel, and a projection of any first sub-pixel, any second sub-pixel, or any third sub-pixel on the drive backplane is located within a projection of any sub-pixel above the first sub-pixel, the second sub-pixel, or the third sub-pixel on the drive backplane; and the first device layer emits red light in a working state, the second device layer emits green light in a working state, and the third device layer emits blue light in a working state. The pixel unit in this application effectively improves the pixel density through a vertically coaxially stacked manner. Based on this, it can be implemented that volumes of sub-pixels in different device layers are adjusted to satisfy different color configuration requirements.

Further, in this application, the fill layer included in the device layer is set to allow light of a lower device layer to transmit through, and luminance of a light source is improved while multi-color display is achieved for a light source reflection manner of an upper device layer.

Further, when any one of the first sub-pixel, the second sub-pixel, and the third sub-pixel is one of a hemisphere, a semi-ellipsoid, or a cylinder with a hemispherical light-emitting surface, and all sub-pixels are equal in volume, a projection of any sub-pixel on the drive backplane does not coincide with a projection of any anode electrical connection structure on the drive backplane. In this application, light extraction efficiency is increased by optimizing a sub-pixel structure, and luminance of the sub-pixel is improved by more than 30%.

Further, when any one of the first sub-pixel, the second sub-pixel, and the third sub-pixel is a cuboid, any anode electrical connection structure is embedded in a corresponding first sub-pixel, and a projection of any anode electrical connection structure on the drive backplane is located within a projection of any third sub-pixel on the drive backplane. The anode electrical connection structure of the pixel unit in this application is disposed below the sub-pixel, so that compared with the existing manner in which the anode electrical connection structure is disposed laterally, a space loss caused by electrical connection can be effectively avoided to increase an effective light-emitting area, and structural reliability of the pixel unit is increased. More importantly, the sub-pixel of the cuboid structure can extend infinitely in the periphery to increase a light-emitting area ratio of each sub-pixel, to improve a pixel density.

It should be noted that this application only needs to achieve the at least one technical effect.

### BRIEF DESCRIPTION OF THE DRAWINGS

FIG. 1 is a top view of a pixel unit in Embodiment 1;
FIG. 2 is a section view of a cross section A-B in FIG. 1 in a pixel unit structure;
FIG. 3 is a section view of a cross section A-B in FIG. 1 in another pixel unit structure;
FIG. 4 is an exemplary structural diagram of a drive circuit;
FIG. 5 is an exemplary structural diagram of a circuit corresponding to a device layer;
FIG. 6 is a top view of a drive backplane after an anode fill layer is formed;
FIG. 7 is a cross sectional view after a drive backplane covers a bonding layer during unaligned bonding;
FIG. 8 is a cross sectional view after a first target compound semiconductor covers a bonding layer during unaligned bonding;
FIG. 9 is a cross sectional view after unaligned bonding of a drive backplane and a first target compound semiconductor;
FIG. 10 is a schematic structural diagram of constructing a first sub-pixel after unaligned bonding;
FIG. 11 is a cross sectional view after a drive backplane covers a bonding layer during aligned bonding;
FIG. 12 is a cross sectional view after a first target compound semiconductor covers a bonding layer during aligned bonding;
FIG. 13 is a cross sectional view after aligned bonding of a drive backplane and a first target compound semiconductor;
FIG. 14 is a schematic structural diagram of constructing a first sub-pixel after aligned bonding;
FIG. 15 is a schematic structural diagram of a first sub-pixel after rough processing;
FIG. 16 is a schematic structural diagram after a first passivation layer and a first ohmic layer are covered;
FIG. 17 is a schematic structural diagram after an anode electrical connection structure is constructed;
FIG. 18 is a schematic structural diagram after a first fill layer is filled;
FIG. 19 is a schematic structural diagram after a second sub-pixel is constructed;
FIG. 20 is another schematic structural diagram after a second sub-pixel is constructed;
FIG. 21 is a schematic structural diagram after a second device layer is constructed;
FIG. 22 is a section view of a cross section A-B of a pixel unit structure in Embodiment 2;
FIG. 23 is a schematic structural diagram of a microdisplay in Embodiment 3; and
FIG. 24 is a schematic structural diagram of a pixel-level discrete device in Embodiment 4.

Reference numerals:
100-Pixel unit, 10-Drive backplane, 11-First anode, 12-Second anode, 13-Third anode, 111-Anode fill layer, 20-Display unit, 30-First device layer, 31-First sub-pixel, 32-First medium layer, 33-First passivation layer, 34-First ohmic layer, 35-First fill layer, 36-First conductive layer, 40-Second device layer, 41-Second sub-pixel, 42-Second medium layer, 43-Second passivation layer, 44-Second ohmic layer, 45-Second fill layer, 46-First bus layer, 47-Second conductive layer, 50-Third device layer, 51-Third sub-pixel, 52-Third medium layer, 53-Third passivation layer, 54-Third ohmic layer, 55-Third fill layer, 56-Second bus layer, 57-Third conductive layer, 60-Anode electrical connection structure, 70-Reinforcement structure, 81-Optical lens, 82-Color conversion layer, 91-First target compound semiconductor, 200-Microdisplay, 300-Microdisplay backplane, 400-Display area, 500-Peripheral common cathode, 600-External IO interface, 700-Pixel-level discrete device, 710-Discrete device backplane, 720-Device body, and 730-Anode pad.

### DETAILED DESCRIPTION

To make objectives, technical solutions, and advantages of this application clearer, the technical solutions in the embodiments of this application will be clearly and completely described below in combination with the accompanying drawings in the embodiments of this application. Obviously, the described embodiments are a part of the embodiments of this application, rather than all of the embodiments. All other embodiments obtained by a person of ordinary skill in the art based on the embodiments of this application without creative efforts shall fall within the protection scope of this application.

In the description of this application, it should be understood that the orientations or positional relationships indicated by the terms "upper", "lower", "inside", "outside", and the like are based on the orientations or positional relationships shown in the accompanying drawings. These terms are merely for ease and brevity of description of this application rather than indicating or implying that the apparatuses or elements mentioned need to have specific orientations or need to be constructed or manipulated according to specific orientations, and therefore shall not be construed as any limitations on this application. In addition, terms "first" and "second" are used merely for the purpose of description, and shall not be construed as indicating or implying relative importance or implying a quantity of indicated technical features. Therefore, a feature limited by "first" or "second" may explicitly or implicitly include one or more of the features. In the description of this application, unless otherwise stated, "a plurality of" means two or more than two.

In the description of this application, it should be noted that, unless specifically defined and limited otherwise, meanings of terms "connected with", and "connected to" should be understood in a board sense. For example, the connection may be a fixed connection, a removable connection, or an integral connection; may be a mechanical connection or an electrical connection; may be a direct connection or an indirect connection by using an intermediate medium; or may be intercommunication between two components. For a person of ordinary skill in the art, the specific meanings of the foregoing terms in this application may be understood according to specific circumstances.

### Embodiment 1

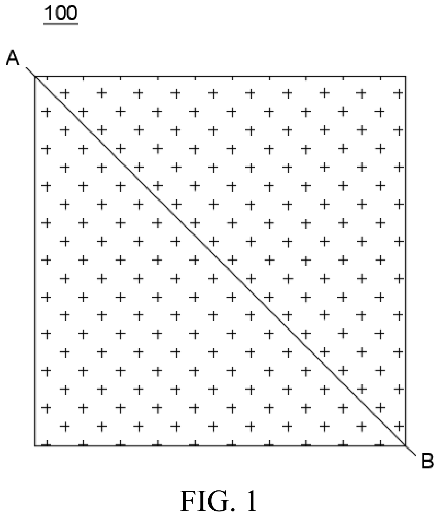

As shown in FIG. 1 to FIG. 3, this embodiment provides a pixel unit 100. The pixel unit 100 is applied to a semiconductor device, and the semiconductor device includes, but is not limited to, a Micro-LED, a Micro-Laser, and another optoelectronic device. The pixel unit 100 includes a drive backplane 10 and a display unit 20 disposed on the drive backplane 10.

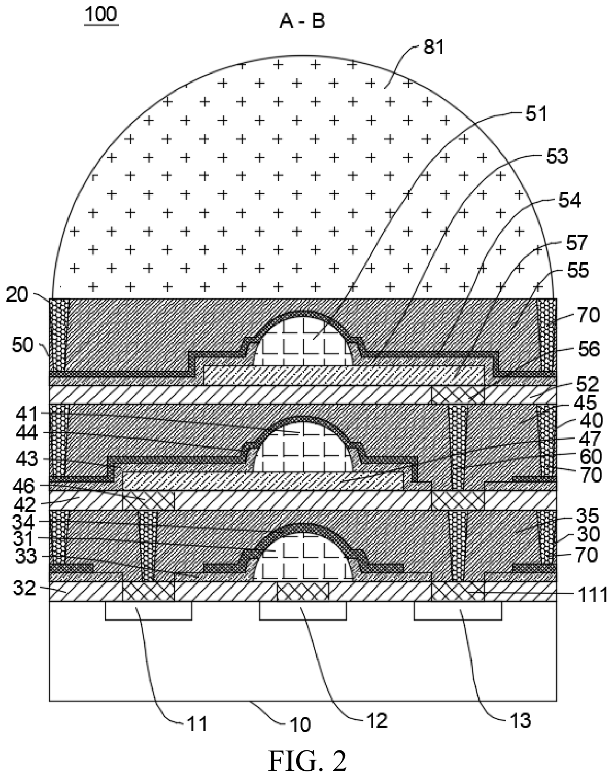

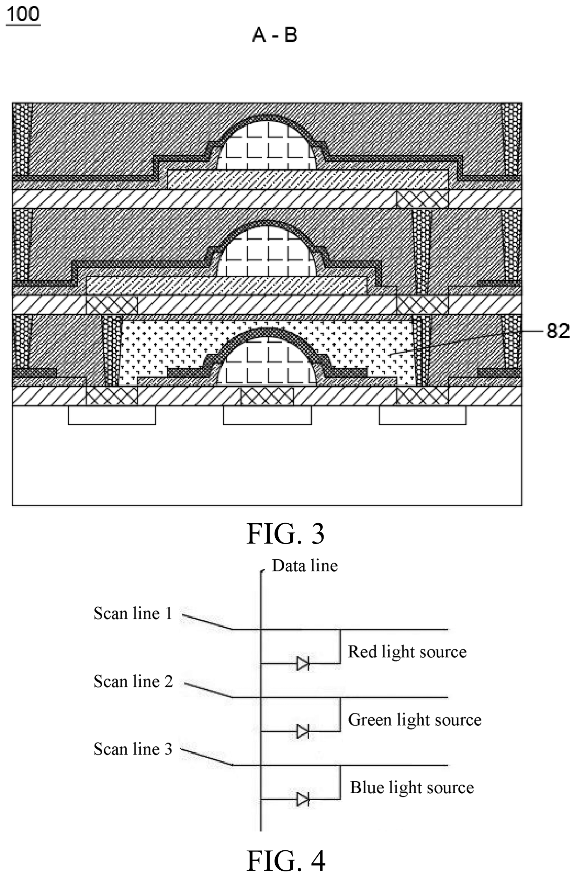

Note: FIG. 1 is a top view of a pixel unit 100, FIG. 2 and FIG. 3 are respectively section views of a cross section A-B of a pixel unit 100 in FIG. 1 in different structures, and subsequent structural diagrams are also top views of a current structure or corresponding section views of the cross section A-B.

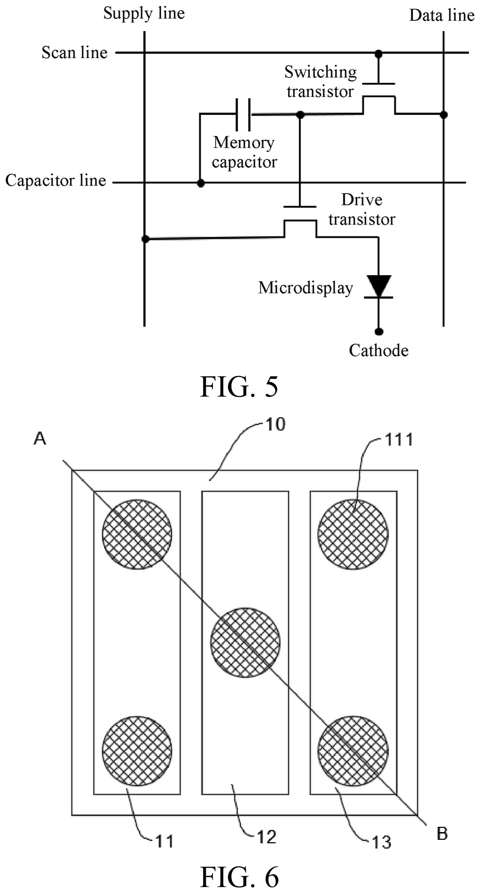

The drive backplane 10 in this embodiment may be an active backplane combining one or more of a thin film transistor (TFT), an LTPS low-temperature polycrystalline silicon, a CMOS integrated circuit, and a high electron mobility transistor (HEMT). Specifically, the drive backplane 10 is provided with a drive circuit, and the drive circuit 10 is provided with at least one anode. For example, a circuit structure diagram of the drive circuit is shown in FIG. 4. It should be noted that the circuit diagram presented in this embodiment is merely a simple schematic diagram. The drive circuit may include an active, passive, or semi-passive control circuit. FIG. 5 is an exemplary circuit diagram of any device layer. All anodes included in the drive circuit may be arranged linearly or arranged in an array, and any anode is located in the middle or at the edge of the drive backplane 10. This is not limited in this embodiment.

In some implementations, the drive backplane 10 includes at least one top metal (Top Metal), and the top metal covers at least one anode. Alternatively, the drive backplane 10 includes an in-situ reflector disposed on an upper surface of the drive backplane 10, and the in-situ reflector covers or exposes at least one anode. The in-situ reflector may be a metal such as aluminum, gold, or silver, or may be a Bragg reflecting layer. The Bragg reflecting layer is formed by a stack of two or more films having different refractive indexes, for example, a stack of silicon oxide and titanium oxide, a stack of silicon oxide and aluminum oxide, or a stack of silicon oxide and silicon nitride, or may be an ODR total reflector stacked with metal and dielectric, for example, at least one combination of silver and silicon oxide, aluminum and aluminum oxide, and gold and silicon oxide.

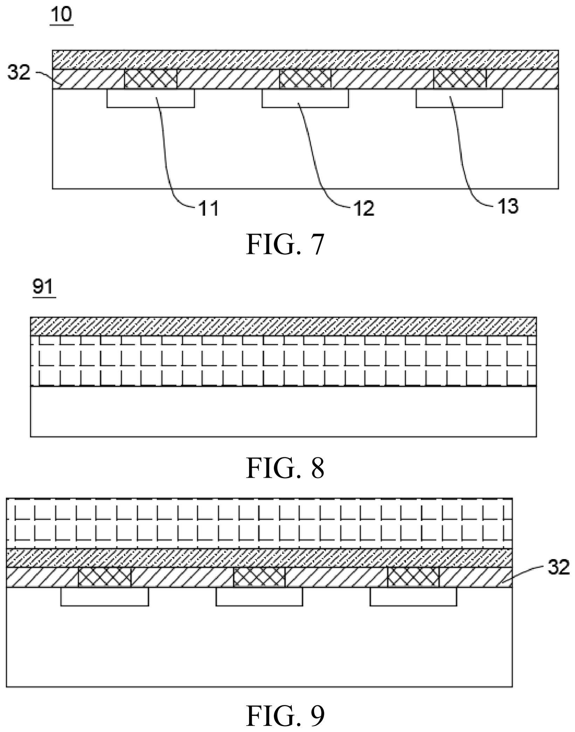

For example, in this embodiment, the drive circuit in the drive backplane 10 includes at least three anodes, and all anodes are arranged in parallel. As shown in FIG. 6 and FIG. 7, the at least three anodes include a first anode 11, a second anode 12, and a third anode 13.

The pixel unit 100 provided in this embodiment are vertically stacked pixels (Vertically Stacked Pixels, VSP for short). Compared with a pixel unit in which different sub-pixels are disposed in a same horizontal direction, the VSP can effectively improve a pixel density.

Refer to FIG. 2, the display unit 20 includes a first device layer 30, a second device layer 40, and a third device layer 50 that are sequentially vertically stacked along a direction away from the drive backplane 10. The first device layer 30 includes at least one first sub-pixel 31, the second device layer 40 includes at least one second sub-pixel 41, the third device layer 50 includes at least one third sub-pixel 51, and a projection of any first sub-pixel 31, any second sub-pixel 41, or any third sub-pixel 51 on the drive backplane 10 is located within a projection of any sub-pixel above the first sub-pixel 31, the second sub-pixel 41, or the third sub-pixel 51 on the drive backplane 10.

In some implementations, the display device 20 further includes a top via (Top Via) corresponding to each anode, and the top via is filled with a metal to form an anode fill layer. Distribution and a shape of the anode fill layer are determined by using a redistribution layer (RDL) process.

As described above, the pixel unit 100 in this embodiment can implement RGB full color display. The first device layer 30 emits red light in a working state, the second device layer 40 emits green light in a working state, and the third device layer 50 emits blue light in a working state. When any one of the device layers is separately lighted, colorful display can be implemented, and when three device layers are simultaneously lighted, white light display can be implemented. Therefore, the first sub-pixel 31 is made of an InGaN ternary material system or a quaternary AlGaInP red light compound with a GaAs substrate, and a corresponding substrate material may be GaAs, Si, Sapphire, or Ga₂O₃. The second sub-pixel 41 is made of a green light InGaN ternary material system, the third sub-pixel 51 is made of a blue light InGaN ternary material system, and a corresponding substrate is GaN, Si, SiC, Sapphire, or the like.

In this embodiment, any one of the first sub-pixel 31, the second sub-pixel 41, and the third sub-pixel 51 is one of a hemisphere, a semi-ellipsoid, or a cylinder with a hemispherical light-emitting surface. A hemispherical or quasi-hemispherical sub-pixel can increase light extraction efficiency, and is verified to improve pixel brightness by more than 30%.

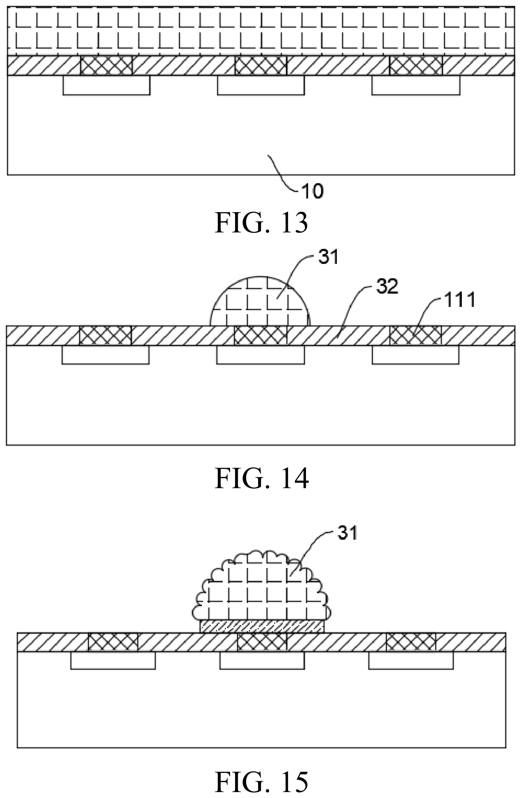

As described above, as shown in FIG. 15, the first sub-pixel 31, the second sub-pixel 41, or the third sub-pixel 51 is provided with surface rough processing, to further enhance the light extraction efficiency.

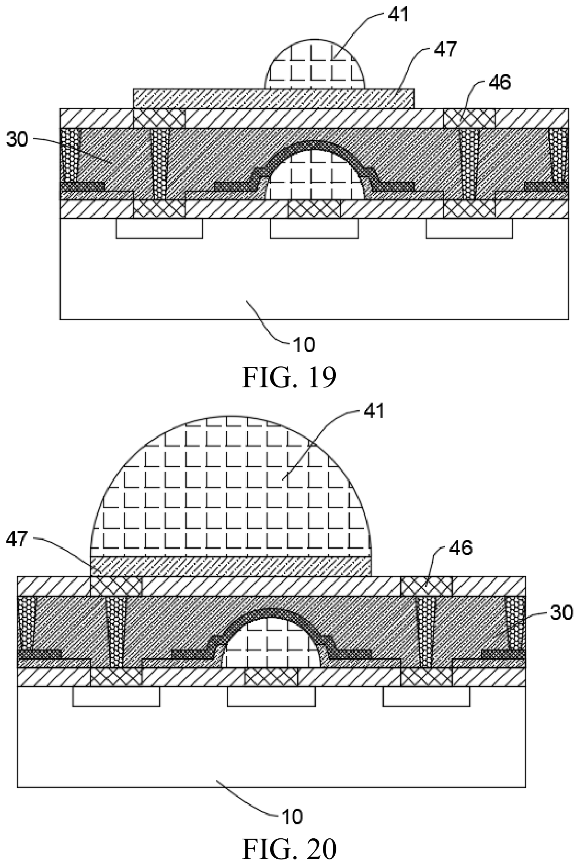

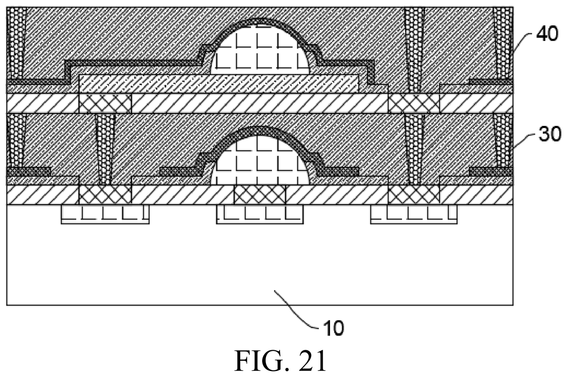

In a structure, a central point of any one of the first sub-pixel 31, the second sub-pixel 41, and the third sub-pixel 51 is located on a same vertical line of the drive backplane 10. In the structure, a volume of any sub-pixel is equal to or greater than a volume of any sub-pixel located below the sub-pixel, as shown in FIG. 2, FIG. 19, and FIG. 21. In another structure, a central point of at least one of the first sub-pixel 31, the second sub-pixel 41, and the third sub-pixel 51 is located outside the same vertical line of the drive backplane 10. As shown in FIG. 20, in this structure, a volume of any sub-pixel is greater than a volume of any sub-pixel located below the sub-pixel. Both of the foregoing two structures are coaxially vertically stacked structures of related sub-pixels on different device layers considered in this embodiment.

Still refer to FIG. 2 and FIG. 6, corresponding to the at least three anodes disposed on the drive backplane 10, the first device layer 30 is provided with at least three top via corresponding to the first anode 11, and any top via is filled with a metal conductive material to form an anode fill layer 111. Each anode fill layer 111 corresponds to an anode, to facilitate subsequent construction of an anode electrical connection between a device layer and an anode. In a preferred implementation, at least one point of any anode fill layer 111 in at least three anode fill layers 111 is located on a same straight line of the drive backplane 10. For example, center points of the three anode fill layers 111 are respectively disposed on a same diagonal of the drive backplane 10, and the diagonal is located within the cross section A-B. As shown in FIG. 6, anode fill layers 111 respectively corresponding to the first anode 11 and the third anode 13 are respectively located at two opposite vertexes of the drive backplane 10, and an anode fill layer 111 corresponding to the second anode 12 is located at the center of the drive backplane 12. Certainly, to subsequently stack more redundant device layers to improve reliability of the pixel unit 100 and luminance of a light source, a quantity of the anode fill layers 111 may be four or even more. For example, there are two anode fill layers 111 corresponding to the first anode 11 and two anode fill layers 111 corresponding to the third anode 13. For ease of description, in this embodiment, a structure is presented along the cross section A-B and a specific description is provided below. Based on this, a further technical solution also falls within an implementation scope of this embodiment.

Therefore, in a structure, any first sub-pixel 31 is connected to a corresponding anode fill layer 111 to implement anode electrical connection, and a corresponding bonding process is aligned bonding.

As described above, the first device layer 30 further includes a first medium layer 32, a first passivation layer 33, a first ohmic layer 34, and a first fill layer 35. The first medium layer 32 is fully covered on the drive backplane 10, and any one of the foregoing anode fill layers 111 is embedded in the first medium layer 32. Any first sub-pixel 31 is disposed on a surface of the first medium layer 32 on a side away from the drive backplane 10, and any first sub-pixel 31 is connected above the anode fill layer 111 corresponding to the first anode 11. The first passivation layer 33 also has a full-surface structure, and is covered on any first sub-pixel 31 and the surface of the first medium layer 32 away from the drive backplane 10. Certainly, the first passivation layer 33 is provided with an opening corresponding to any first sub-pixel 31 and an opening corresponding to any anode fill layer 111. The first ohmic layer 34 also has a full-surface structure, and the first passivation layer 33 is provided with an opening corresponding to any anode fill layer 111. The first ohmic layer 34 is connected to any first sub-pixel 31 through the opening of the first passivation layer 33, to implement cathode connection to any first sub-pixel 31.

Therefore, all of the first medium layer 32, the first passivation layer 33, and the first ohmic layer 34 in the first device layer 30 have a full-surface structure provided with at least one opening. The first medium layer 32 is made of a transparent or non-transparent dielectric material, which may be silicon oxide, silicon nitride, aluminum oxide, aluminum nitride, or the like, or may be made of a type material of organosilicon such as silicone-modified polyimide (PI), polymethyl methacrylate (PMMA), or photoresist (SU8). The first passivation layer 33 is made of a transparent dielectric material such as silicon oxide, silicon nitride, aluminum oxide, or aluminum nitride. The anode fill layer 111 is made of a conductive material, for example, a metal or a stack of Al, Cu, Au, W, or Ti, or may be a metal oxide material such as ITO or ZnO. The first ohmic layer 34 is made of a transparent electrically conductive material, for example, a transparent electrically conductive metal oxide such as ITO or ZnO, or alloy or a stack of a thin metal such as Al, Au, Ge, Ni, or Cr, or may be a mixture of a metal oxide and a metal, for example, ITO and Al, ITO and Au, or ITO and Ag. The first fill layer 35 is made of a transparent dielectric material such as silicon oxide, silicon nitride, aluminum oxide, or aluminum nitride.

The first fill layer 35 encapsulates any first sub-pixel 31, and is configured to fill and planarize the first device layer 30. The first fill layer 35 is made of a transparent dielectric material, and preferably, the transparent dielectric material used for the first fill layer 35 has a light screening function, allows a light source (red light) of the first sub-pixel 31 to transmit through, and has a reflection function for a light source (green light) of the second sub-pixel 41 and a light source (blue light) of the third sub-pixel 51. Specifically, a transmittance of the first fill layer 35 for visible light in a band (a red light band) from 600 nm to 650 nm is not less than 90%, and a reflectivity of the first fill layer 35 for visible light in a band (a green light band) from 500 nm to 550 nm is not less than 90%. This can effectively improve a light transmittance of the pixel unit 100 stacked vertically and coaxially, and avoid light loss.

The foregoing is a structure when aligned bonding is used between the first device layer 30 and the drive backplane 10.

When unaligned bonding is used between the first device layer 30 and the drive backplane 10, a difference from the aligned bonding lies in that: the first device layer 30 further includes at least one first conductive layer 36, any first conductive layer 36 is disposed between any first sub-pixel 31 and the first medium layer 32, and the first conductive layer 36 is connected to a corresponding anode fill layer 111 to implement anode electrical connection of the first sub-pixel 31.

As described above, the second device layer 40 further includes a second medium layer 42, a second passivation layer 43, a second ohmic layer 44, a second fill layer 45, and at least two first bus layers 46. The second passivation layer 43 is covered on a surface of any second sub-pixel 41, the second ohmic layer 44 is covered on a surface of the second passivation layer 43, and the second ohmic layer 44 is connected to any second sub-pixel 41 through the second passivation layer 43. Materials used for layers of the second device layer 40 are basically the same as those used for the first device layer 30. The second ohmic layer 44 has a full-surface film structure made of a transparent conductive material, and the second passivation layer 43 has a full-surface film structure made of a transparent dielectric material. Both the second ohmic layer 44 and the second passivation layer 43 are provided with a plurality of opening for electrical connection between the device layer and an upper device layer. The second ohmic layer 44 is attached to a corresponding second sub-pixel 41 through an opening provided in the second passivation layer 43, to construct a cathode electrical connection of the second device layer 40.

Preferably, the transparent dielectric material used for the second fill layer 45 has a light screening function, a transmittance for visible light in a band from 600 nm to 650 nm and a band from 500 nm to 550 nm is not less than 90%, and a reflectivity of the second fill layer 45 for visible light in a band from 400 nm to 460 nm is not less than 90%. That is, the second fill layer 45 allows the light source (red light) of the first sub-pixel 31 and the light source (green light) of the second sub-pixel 41 to transmit through, and has a reflection function for the light source (blue light) of the third sub-pixel 51.

Any first bus layer 46 is embedded in the second medium layer 42, and any first bus layer 46 is located above any anode fill layer 111. At least one first bus layer 46 is configured for anode electrical connection of the second sub-pixel 41. The first device layer 30 further includes at least one anode electrical connection structure 60. One end of any anode electrical connection structure 60 in the first device layer 30 is connected to the anode fill layer 111, and the other end is connected to a corresponding first bus layer 46. Therefore, the second device layer 40 implements anode electrical connection by using the first bus layer 46, the anode electrical connection structure 60, and the anode fill layer 111 that are sequentially connected.

Preferably, the second device layer 40 in the structure further includes a second conductive layer 47. One side of the second conductive layer 47 is connected to the second sub-pixel 41, and the other side of is connected to a corresponding first bus layer 46. It may be understood that the structure is implemented by using an unaligned bonding process.

Based on this, in a structure, as shown in FIG. 2, when volumes of sub-pixels at each device layer are all equal, center points of all sub-pixels are located on a same straight line. To prevent the anode electrical connection structure 60 of the upper device layer from damaging or shielding a sub-pixel at a lower layer, a projection of the second conductive layer 47 on the drive backplane 10 is greater than a projection of the second sub-pixel 41 on the drive backplane 10. That is, the second conductive layer 47 extends laterally to be connected to a corresponding first bus layer 46, so that the second sub-pixel 41 is connected to the second anode 12 by using the second conductive layer 47, the first bus layer 46, the anode electrical connection structure 60, and the anode fill layer 111 that are sequentially connected, thereby implementing anode electrical connection.

In another structure, as shown in FIG. 20, when a volume of the second sub-pixel 41 is greater than a volume of a corresponding first sub-pixel 31, a projection of the second sub-pixel 41 on the drive backplane 10 is greater than a projection of the first sub-pixel 31 on the drive backplane 10. Therefore, an anode electrical connection structure 60 is constructed vertically above a portion of the second sub-pixel 41 that extends beyond the first sub-pixel 31 in a horizontal direction, to implement anode electrical connection. That is, when a volume of the second sub-pixel 41 is greater than a volume of a corresponding first sub-pixel 31, a projection of an anode electrical connection structure 60 corresponding to the second sub-pixel 41 on the drive backplane 10 is located within the projection of the second sub-pixel 41 on the drive backplane 10, and the anode electrical connection structure 60 and the first sub-pixel 31 are disposed at an interval.

In this structure, volumes and a relative position relationship of the first sub-pixel 31 and the second sub-pixel 41 in a horizontal direction may be adjusted with reference to an optical requirement and a physical structure requirement, and anode electrical connection of each device layer is implemented with reference to an anode electrical connection structure 60 of a sub-pixel at each corresponding position. Therefore, in the pixel unit 100 in the structure, subject to the above conditions, each device layer allows for customizable adjustment of a position and a volume of any sub-pixel to meet diverse color configuration requirements, offering significant flexibility.

Similarly, the third device layer 50 further includes a third medium layer 52, a third passivation layer 53, a third ohmic layer 54, a third fill layer 55, a second bus layer 56, and a third conductive layer 57. The third passivation layer 53 is covered on a surface of any third sub-pixel 51, the third ohmic layer 54 is covered on a surface of the third passivation layer 53, and the third ohmic layer 54 is connected to any third sub-pixel 51 through the third passivation layer 53. Similar to the second device layer 40, the third passivation layer 53 and the third ohmic layer 54 have a full-surface structure provided with a corresponding opening. The third medium layer 52, the third conductive layer 57, the third sub-pixel 51, the third passivation layer 53, and the third ohmic layer 54 are sequentially stacked in a direction away from the drive backplane 10. Moreover, a volume of any third sub-pixel 51, compared with any sub-pixel located below the third sub-pixel 51, may be enlarged or the same. Certainly, disposition manners of a corresponding third conductive layer 57 and a corresponding anode electrical connection structure 60 are the same as those of the second device layer 40. For details, refer to the foregoing description.

Preferably, a transparent dielectric material used for the third fill layer 55 has a light screening function, and a transmittance for visible light in a band from 600 nm to 650 nm, a band from 500 nm to 550 nm, and a band from 400 nm to 460 nm is not less than 90%. That is, the third fill layer 55 allows the light source (red light) of the first sub-pixel 31, the light source (green light) of the second sub-pixel 41, and the light source (blue light) of the third sub-pixel 51 to transmit through.

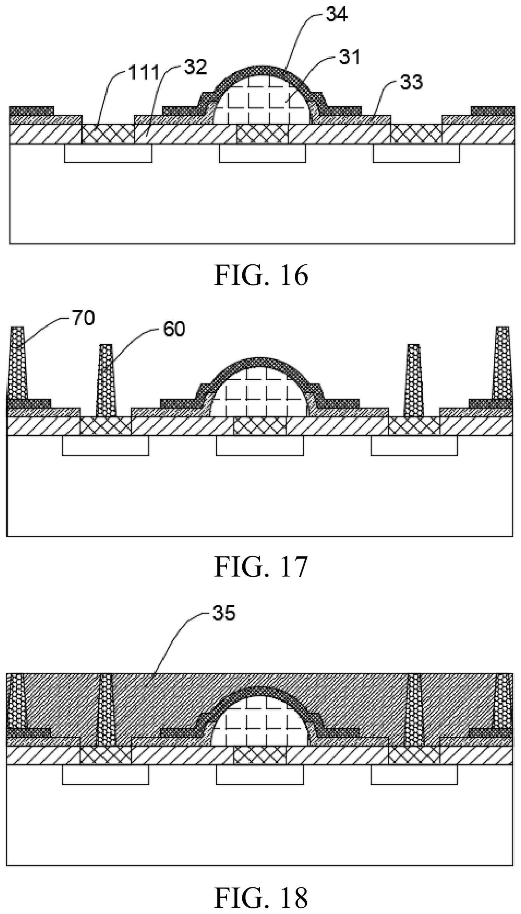

As described above, as shown in FIG. 2 and FIG. 17, any device layer further includes a reinforcement structure 70. The reinforcement structure 70 is surrounded around a periphery of each device layer. The reinforcement structure 70 is made of metal material filling, and is used for optical enhancement and structural stability enhancement. Specifically, one end of the reinforcement structure 70 is connected to the ohmic layer of the device layer, and the other end is connected to a passivation layer of an upper device layer.

As described above, as shown in FIG. 2, an optical lens 81 is further included above the display unit 20. The optical lens 81 has a hemispherical structure and is made of an inorganic transparent dielectric material or an organic transparent dielectric material. In this embodiment, the optical lens 81 is disposed to further improve a luminous brightness and optimize a luminous angle of the pixel unit 100.

As described above, as shown in FIG. 3, any one of the first device layer 30, the second device layer 40, and the third device layer 50 further includes a color conversion layer 82 disposed above any sub-pixel, and the color conversion layer 82 absorbs an excitation light source emitted by a corresponding sub-pixel and converts the excitation light source into a target light source. For example, the first device layer 30 further includes a color conversion layer 82 disposed above any sub-pixel. The color conversion layer 82 extracts an excitation light source emitted by the first sub-pixel 31 and converts the excitation light source into a red light. In this structure, the first sub-pixel 31 is fabricated by using a blue light InGaN compound or a green light InGaN compound to form the excitation light source, and is fabricated by using a red light quantum dot material or a red phosphor material to form the color conversion layer 82. Specifically, the red light quantum dot material may be one or a mixture of a perovskite red light quantum dot material, a CsPdI₃ material, an InP material, a CdSe material, or a CdS material.

Corresponding to the pixel unit 100, this embodiment further provides a fabricating method for a pixel unit 100, and the fabricating method includes the following steps.

S10: Prepare a drive backplane 10.

This embodiment preferably uses a CMOS integrated circuit backplane, which is provided with a top metal, and includes a common cathode disposed on a periphery. The drive backplane 10 has a plurality of anodes. In this embodiment, to implement full color display, at least three anodes are provided: a first anode 11, a second anode 12, and a third anode 13, which respectively correspond to sub-pixels of three colors: R (red), G (green), and B (blue). This embodiment does not limit a distribution manner of each anode, and each anode may have a multi-channel redundant structure.

Particularly, to match subsequent optoelectronic requirements of device layers, electrical channel reconstruction is performed on the CMOS integrated circuit backplane by using a redistribution layer (RDL) technology, that is, a medium layer, a top via, and an anode fill layer are disposed on the drive backplane 10 by using a semiconductor process.

Specific steps are as follows:
S101: Plate an entire medium layer on a surface of the drive backplane 10, where the medium layer may be a medium material such as silicon oxide, silicon nitride, aluminum oxide, aluminum nitride, or may be a type material of an organosilicon such as PI, PMMA, or SU8.
S102: Form a plurality of top via on the medium layer by using a patterning process.
S103: Fill each top via with a conductive material to form a corresponding anode fill layer, where the conductive material includes a metal or a stack of Al, Cu, Au, W, or Ti, or may be a metal oxide material such as ITO or ZnO.

In this embodiment, as shown in FIG. 6, two anode fill layers corresponding to the first anode 11, one anode fill layer corresponding to the second anode 12, and two anode fill layers corresponding to the third anode 13 are formed.
S20: Fabricate a display unit 20, including the following steps.
S210: As shown in FIG. 7 to FIG. 18, bond a first target compound semiconductor 91 to the drive backplane 10 and construct at least one first sub-pixel 31 to form a first device layer 30.
S220: As shown in FIG. 19 to FIG. 21, bond a second target compound semiconductor to the first device layer 30 and construct at least one second sub-pixel 41 to form a second device layer 40.
S230: Bond a third target compound semiconductor to the second device layer 40 and construct at least one third sub-pixel 51 to form a third device layer 50, as shown in FIG. 2 or FIG. 3.

A projection of any first sub-pixel 31, any second sub-pixel 41, or any third sub-pixel 51 on the drive backplane 10 is located within a projection of any sub-pixel above the first sub-pixel 31, the second sub-pixel 41, or the third sub-pixel 51 on the drive backplane 10. The first device layer 30 emits red light in a working state, the second device layer 40 emits green light in a working state, and the third device layer 50 emits blue light in a working state.

Specifically, step S210 includes the following steps.

S211: Prepare the first target compound semiconductor 91.

The compound semiconductor in this embodiment is usually a wafer or an area of an appropriate size that is cut from a wafer. The wafer has semiconductor properties such as a determined forbidden band width and an energy band structure. The wafer includes a crystalline inorganic compound (for example, a III-V group or II-VI group compound semiconductor), an organic compound (for example, an organic semiconductor), an oxide semiconductor, or the like, which may be flexibly combined during subsequent VSP compound stacking. The wafer includes a compound extension and a substrate. In this embodiment, a compound extension material used for a red light sub-pixel is an InGaN ternary material system extension or a quaternary AlGaInP red light compound extension, and a substrate material thereof may be GaAs, Si, Sapphire, Ga₂O₃, or the like. A compound semiconductor material used for a blue light sub-pixel/green light sub-pixel is a ternary material system of green light InGaN or blue light InGaN, and a substrate material thereof may be GaN, Si, SiC, Sapphire, or the like. Specifically, a direction of the compound extension towards the substrate sequentially includes a P contact (P contact), a multiple quantum well (MQW) active layer, an N contact (N contact), and an etch stop layer.

In this embodiment, the first target compound semiconductor 91 is made of an InGaN ternary material system extension or a quaternary AlGaInP red light compound extension, and a specific structure is shown in the following Table 1 or Table 2.

**Table 1**

| Layer names | Materials |
|---|---|
| P contact | P-GaAs |
| Multiple quantum well active layer | AlGaInP |
| N contact | N-GaAs |
| Etch stop layer | N-AlGaInP |
| Substrate | GaAs |

**Table 2**

| Layer names | Materials |
|---|---|
| P contact | P-GaN |
| Multiple quantum well active layer | InGaN&GaN |
| N contact | N-GaN |
| Etch stop layer | AlN&GaN |
| Substrate | Si |

S212: Bond the first target compound semiconductor 91 to the drive backplane 10. The bonding manner in this step may be aligned bonding or unaligned bonding.

When the unaligned bonding is used, as shown in FIG. 7 to FIG. 10, the following steps are included.

S212a1: Perform ohmic contact layer preparation on the P contact of the first target compound semiconductor 91.

S212a2: Plate an entire bonding layer on a surface of the first target compound semiconductor 91.

S212a3: Plate an entire bonding layer on the surface of the drive backplane 10 obtained in S103.

S212a4: Bond a bonding surface of the first target compound semiconductor 91 obtained in S212b2 to a bonding surface of the drive backplane 10 obtained in S212a3.

In step S212a4, an anode fill layer constructed on the surface of the drive backplane 10 is the anode fill layer 111 of the first device layer 30.

S212a4: Remove the substrate of the first target compound semiconductor 91 through wet etching to expose the first target compound semiconductor 91 to the N contact.

As described above, when the unaligned bonding is used, in step S212b4, an ohmic contact layer and a bonding layer of the P contact of the first target compound semiconductor 91 are combined into the first conductive layer 36, which is disposed between the drive backplane 10 and the multiple quantum well active layer.

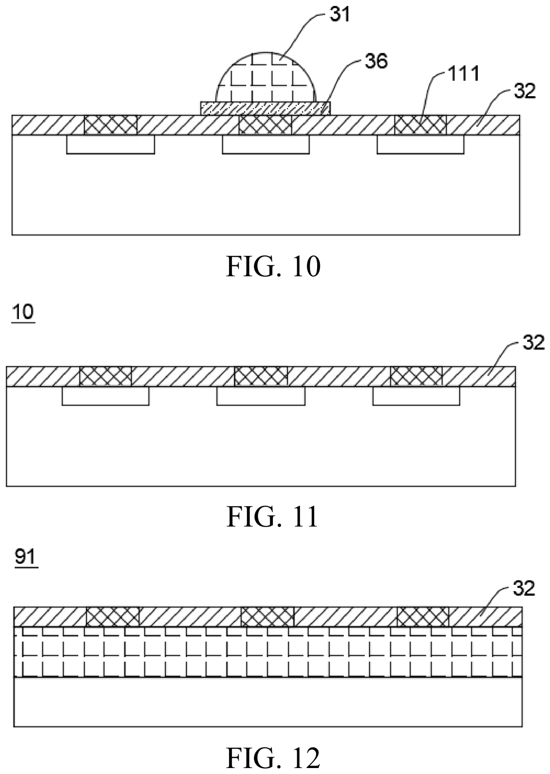

When aligned bonding is used, as shown in FIG. 11 to FIG. 14, the following steps are included.

S212b1: Perform ohmic contact layer preparation on the P contact of the first target compound semiconductor 91, where a contact material may be a transparent conductive material such as ITO or ZnO, or may be a stack or alloy of metal materials such as Ni, Au, Ag, Be, and Zn.

For example, a GaAs-based red light AlGaInP compound is used, and AuBe alloy coating is carried out through methods such as evaporation or sputtering. A thickness of an AuBe alloy film is 60 nm, and ohmic contact is formed through high-temperature annealing at 410 °C in an N₂ environment. The thickness and formation conditions of the ohmic contact layer plated on the surface of this compound can be adjusted and changed according to requirements.

S212b2: Plate an entire medium layer on a surface of the first target compound semiconductor 91, form a plurality of via on the medium layer by using a patterning process, and fill each via with a conductive material to form a corresponding anode fill layer, where distribution of anode fill layers in this step corresponds to distribution of the top via in step S103.

S212b3: Perform patterning bonding layer plating on the first target compound semiconductor 91, and perform patterning bonding layer plating on the drive backplane 10 obtained in step S103. Specifically, the bonding layer coating is carried out through sputtering or evaporation of Cr1nm and/or Au50nm. Certainly, a same bonding material is used in one bonding.

S212b4: Bond a surface of the first target compound semiconductor 91 to a surface of the drive backplane 10 on both of which a bonding layer is plated in S212b3.

In step S212b4, the anode fill layer and the bonding layer included in the first target compound semiconductor 91 are stacked on the anode fill layer constructed on the surface of the drive backplane 10 to form the anode fill layer 111 of the first device layer 30.

It should be noted that, chemical mechanical polishing (CMP) is used for planarization before the bonding, so that a flatness of the bonding surface is less than 5 nm, or even less than 0.5 nm.

S212b5: Remove the substrate of the first target compound semiconductor 91 through wet etching to expose the first target compound semiconductor 91 to the N contact.

S213: Construct at least one first sub-pixel 31. As shown in FIG. 16, S213 includes the following substeps.

S2131: Perform patterning expose and etching on the multiple quantum well active layer based on a preset sub-pixel pattern, to form at least one first sub-pixel 31. In this embodiment, the first sub-pixel 31 is one of a hemisphere, a semi-ellipsoid, or a cylinder with a hemispherical light-emitting surface.

Preferably, surface rough processing is performed on the formed first sub-pixel 31 to enhance surface roughness thereof.

When unaligned bonding is used in step S212, in this step, the first conductive layer 36 corresponding to a shape and an electrical connection structure of the first sub-pixel 31 is synchronously formed through etching.

S2132: Plate an entire transparent dielectric material to a surface on which the first sub-pixel 31 is located, to form the first passivation layer 33.

Specifically, the first passivation layer 33 is prepared in a manner such as ALD, CVD, or PVD. The transparent dielectric material includes but is not limited to a single layer or a stack of aluminum oxide, silicon oxide, silicon nitride, aluminum nitride, and the like.

S2133: Provide, through patterning etching, an opening at a position of the first passivation layer 33 corresponding to a top of the first sub-pixel 31, to expose the top of the first sub-pixel 31. In addition, a corresponding opening is simultaneously provided corresponding to the anode fill layer 111 preset to be used as a redundant electrical connection. An etching method includes, but is not limited to, wet etching or dry etching.

S2134: Perform blanket deposition on a surface of the first passivation layer 33 to form the first ohmic layer 34.

Specifically, the first ohmic layer 34 is prepared in a manner such as an electron beam, an ion beam, or sputtering, and through etching, the corresponding opening is provided corresponding to the anode fill layer 111 preset as the redundant electrical connection, to be corresponding to the opening of the first passivation layer 33.

The first ohmic layer 34 is one or a combination of a transparent metal oxide, a metal thin layer, an alloy thin layer, and a metal stack. For example, ITO, ZnO, Al, Au, Ge, Ni, Cr, or Ag. For example, ITO and Al, ITO and Au, or ITO and Ag.

S214: As shown in FIG. 17 and FIG. 18, construct an anode electrical connection structure 60 used for a subsequent device layer and fill the device layer, to form the first device layer 30. This step includes the following two implementations.

In a method, first, at least two anode electrical connection structures 60 are first constructed, then a transparent dielectric material is filled to form a first fill layer 35, and planarization processing is performed on the fill layer to expose an upper end of the anode electrical connection structure 60.

In another method, a device layer is first filled and planarized by using a transparent dielectric material, then a via for constructing a corresponding anode electrical connection structure 60 is formed by using a patterning etching method, and finally, metal filling is performed in the via to form the anode electrical connection structure 60.

As described above, the reinforcement structure 70 disposed around the periphery of the first device layer 30 is constructed through metal filling while the anode electrical connection structure 60 is constructed.

As described above, the first fill layer 35 uses an organic material having a light screening function or a Bragg reflecting layer of a stack of silicon oxide and titanium oxide. The organic material includes a silicone-modified polyimide (PI), polymethyl methacrylate (PMMA), photoresist (SU8), and the like. As described above, a transmittance of the first fill layer 35 for visible light in a band (a red light band) from 600 nm to 650 nm is not less than 90%, and a reflectivity of the first fill layer 35 for visible light in a band (a green light band) from 500 nm to 550 nm is not less than 90%.

After the first device layer 30 is constructed, step S220 is performed. As shown in FIG. 19 to FIG. 21, step S220 includes the following steps.

S221: Plate a bonding layer on a surface of the second target compound semiconductor, plate a bonding layer on a surface of the first device layer 30, and relatively bond the second target compound semiconductor to the first device layer 30.

S222: Construct at least one second sub-pixel 41, a corresponding second medium layer 42 and second ohmic layer 44. A projection of the first sub-pixel 31 on the drive backplane 10 is located within a projection of a corresponding second sub-pixel 41 on the drive backplane 10. That is, the second sub-pixel 41 and the first sub-pixel 31 are coaxially vertically stacked, and a volume of the second sub-pixel 41 is not less than a volume of the first sub-pixel 31. Based on this, flexibility of volume adjustment of the first sub-pixel 31 is high, to satisfy different color configuration requirements. Refer to FIG. 19 and FIG. 20.

S223: Construct an anode electrical connection structure 60 used for a subsequent device layer of the device layer and perform device layer filling, to form a second device layer 40.

In the foregoing steps, the second target compound semiconductor is made of a green light InGaN ternary material system, and an exemplary structure is shown in the following Table 3 or Table 4.

**Table 3**

| Layer names | Materials |
|---|---|
| P contact | P-GaN |
| Multiple quantum well active layer | InGaN&GaN |
| N contact | N-GaN |
| Etch stop layer | AlN&GaN |
| Substrate | Si |

Moreover, the second sub-pixel 42 is one of a hemisphere, a semi-ellipsoid, or a cylinder with a hemispherical light-emitting surface, and needs to construct a lateral anode electrical connection structure 60. Therefore, unaligned bonding is used during bonding in step S221, to construct a second conductive layer 47 having a particular extension length.

As described above, step S230 is performed by using the same method, and the difference lies only in that a third target compound semiconductor 99 is made of a blue light InGaN ternary material system thereof.

In a process of fabricating an RGB pixel unit including three device layers, fabrication of the display unit 20 is completed after S230 is performed. Certainly, implementing a redundant structure in a manner of constructing more device layers on such a basis also falls within the implementation scope of this embodiment this embodiment.

Moreover, after fabrication of the display unit 20 is completed, the fabricating method further includes constructing an optical lens 81 on a side of the display unit 20 away from the drive backplane 10.

In conclusion, the pixel unit in this embodiment effectively improves the pixel density through a vertically coaxially stacked manner. Based on this, it can be implemented that volumes of sub-pixels in different device layers are adjusted to satisfy different color configuration requirements. Moreover, in this embodiment, the fill layer included in the device layer is set to allow light of a lower device layer to transmit through, and luminance of a light source is improved while multi-color display is achieved for a light source reflection manner of an upper device layer. In addition, in this embodiment, light extraction efficiency is increased by constructing a sub-pixel of a hemisphere structure, and luminance of the sub-pixel is improved by more than 30%.

### Embodiment 2

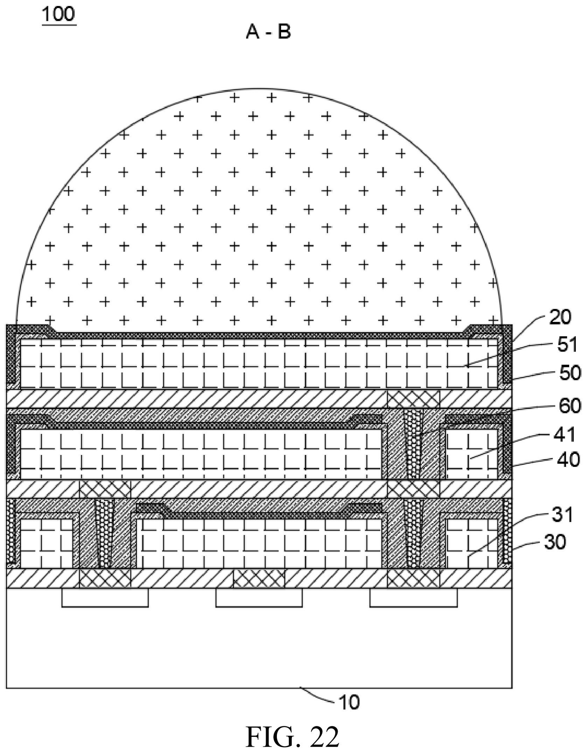

As shown in FIG. 22, this embodiment provides a pixel unit 100 in another structure. The pixel unit 100 includes a drive backplane 10 and a display unit 20 disposed on the drive backplane 10. The display unit 20 includes a first device layer 30, a second device layer 40, and a third device layer 50 that are sequentially vertically stacked along a direction away from the drive backplane 10. The first device layer 30 includes at least one first sub-pixel 31, the second device layer 40 includes at least one second sub-pixel 41, the third device layer 50 includes at least one third sub-pixel 51, and a projection of any first sub-pixel 31, any second sub-pixel 41, or any third sub-pixel 51 on the drive backplane 10 is located within a projection of any sub-pixel above the first sub-pixel 31, the second sub-pixel 41, or the third sub-pixel 51 on the drive backplane 10. The first device layer 30 emits red light in a working state, the second device layer 40 emits green light in a working state, and the third device layer 50 emits blue light in a working state.

A difference between the pixel unit 100 in this embodiment and that in Embodiment 1 lies in that: when any one of the first sub-pixel 31, the second sub-pixel 41, and the third sub-pixel 51 is a cuboid, any anode electrical connection structure 60 in the first device layer 30 is embedded in a corresponding first sub-pixel 31, and a projection of any anode electrical connection structure 60 in the first device layer 30 on the drive backplane 10 is located within a projection of any third sub-pixel 51 on the drive backplane 10. That is, the anode electrical connection structure 60 corresponding to an upper device layer passes through a lower device layer and is connected to a corresponding anode in the drive backplane 10.

It can be learned with reference to FIG. 22 that, any sub-pixel extends to an edge of the device layer in a periphery, so that areas of the first sub-pixel 31, the second sub-pixel 41, and the third sub-pixel 51 are equal in a horizontal direction, and a light-emitting area ratio of each sub-pixel is increased to improve a pixel density.

Similarly, this embodiment further provides a fabricating method for a pixel unit, and the fabricating method is similar to the fabricating method in Embodiment 1. Because in this embodiment, there is no need to laterally construct the anode electrical connection structure 60, aligned bonding is used for bonding between device layers, and no conductive layer needs to be formed.

Therefore, a structure and a fabricating method for the pixel unit 100 in this embodiment are similar to those in Embodiment 1, and are not specifically described in this embodiment. For a specific structure, refer to the description in Embodiment 1.

### Embodiment 3

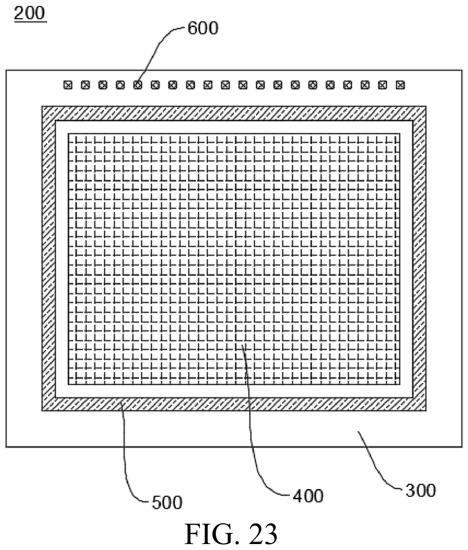

This embodiment provides a microdisplay 200. As shown in FIG. 23, the microdisplay 200 includes:
a microdisplay backplane 300, the microdisplay backplane 300 including at least two drive circuits, an input interface, and an output interface;
a display area 400, the display area 400 being disposed on the microdisplay backplane 300, the display area 400 including at least two display units 20 of the pixel unit 100 in Embodiment 1 or Embodiment 2, and the at least two display units 20 being arranged in an array;
a peripheral common cathode 500, the peripheral common cathode 500 being electrically connected to any ohmic layer included in each display unit 20, so that the entire microdisplay 200 has a common cathode. It should be noted that the peripheral common cathode 500 has a metal surrounding frame structure disposed around the periphery of the display area 400; and
an external IO interface 600, located at any position of the microdisplay backplane 300.

Further, an arrangement orientation of each pixel unit 100 disposed adjacently in an array in the microdisplay 200 is not limited in this embodiment.

For a specific structure of the microdisplay in this embodiment and a corresponding technical effect, refer to related description in Embodiment 1, and it is not further described in detail in this embodiment.

### Embodiment 4

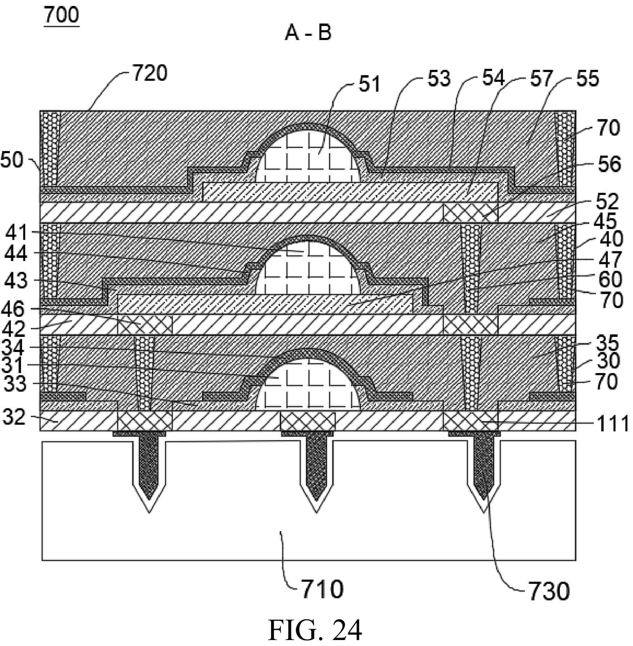

As shown in FIG. 24, this embodiment provides a pixel-level discrete device 700, where the pixel-level discrete device 700 includes:
a discrete device backplane 710, the discrete device backplane 710 including at least three anode pads 730 and at least one cathode pad (not shown in the figure); and
a device body 720, the device body 720 being disposed on the discrete device backplane 710, the device body 720 including at least two display units 20 included in the pixel unit 100 in Embodiment 1 or Embodiment 2, and the at least two display units 20 being arranged in an array.

Any combination of all the foregoing optional technical solutions may be used to form optional embodiments of this application, that is, a plurality of embodiments may be combined randomly, to obtain requirements for dealing with different application scenarios, all of which fall within the protection scope of this application, and details are not described herein again.

It should be noted that the foregoing descriptions are merely preferred embodiments of this application, but are not intended to limit this application. Any modification, equivalent replacement, or improvement made within the spirit and principle of this application shall fall within the protection scope of this application.

## Claims

1. A pixel unit, wherein the pixel unit comprises:
a drive backplane; and
a display unit, the display unit being disposed on the drive backplane, the display unit comprising a first device layer, a second device layer, and a third device layer that are sequentially vertically stacked along a direction away from the drive backplane, the first device layer comprising at least one first sub-pixel, the second device layer comprising at least one second sub-pixel, the third device layer comprising at least one third sub-pixel, and a projection of any first sub-pixel, any second sub-pixel, or any third sub-pixel on the drive backplane being located within a projection of any sub-pixel above the first sub-pixel, the second sub-pixel, or the third sub-pixel on the drive backplane; and
the first device layer emits red light in a working state, the second device layer emits green light in a working state, and the third device layer emits blue light in a working state.

2. The pixel unit according to claim 1, wherein a central point of any one of the first sub-pixel, the second sub-pixel, and the third sub-pixel is located on a same vertical line of the drive backplane.

3. The pixel unit according to claim 1, wherein the first device layer further comprises a first fill layer that encapsulates any first sub-pixel, a transmittance of the first fill layer for visible light in a band from 600 nm to 650 nm is not less than 90%, and a reflectivity of the first fill layer for visible light in a band from 500 nm to 550 nm is not less than 90%;
the second device layer further comprises a second fill layer that encapsulates any second sub-pixel, a transmittance of the second fill layer for visible light in a band from 600 nm to 650 nm and a band from 500 nm to 550 nm is not less than 90%, and a reflectivity of the second fill layer for visible light in a band from 400 nm to 460 nm is not less than 90%; and
the third device layer further comprises a third fill layer that encapsulates any third sub-pixel, and a transmittance of the third fill layer for visible light in a band from 600 nm to 650 nm, a band from 500 nm to 550 nm, and a band from 400 nm to 460 nm is not less than 90%.

4. The pixel unit according to claim 1, wherein the second device layer further comprises a second passivation layer and a second ohmic layer;
the second passivation layer is covered on a surface of any second sub-pixel; and
the second ohmic layer is covered on a surface of the second passivation layer, and the second ohmic layer is connected to any second sub-pixel through the second passivation layer.

5. The pixel unit according to claim 1, wherein the drive backplane comprises at least three anodes, the first device layer further comprises at least three anode fill layers, and any anode fill layer is connected to any corresponding anode; and
at least one point of any anode fill layer in the at least three anode fill layers is located on a same straight line of the drive backplane.

6. The pixel unit according to claim 5, wherein the second device layer further comprises at least two first bus layers, and any first bus layer is located above any anode fill layer; and
the first device layer further comprises at least one anode electrical connection structure, and one end of any anode electrical connection structure in the first device layer is connected to the anode fill layer, and the other end is connected to a corresponding first bus layer.

7. The pixel unit according to claim 5, wherein any first sub-pixel is connected to a corresponding anode fill layer; or
the first device layer further comprises at least one first conductive layer, one side of any first conductive layer is connected to any first sub-pixel, and the other side is connected to a corresponding anode fill layer.

8. The pixel unit according to claim 6, wherein when any one of the first sub-pixel, the second sub-pixel, and the third sub-pixel is one of a hemisphere, a semi-ellipsoid, or a cylinder with a hemispherical light-emitting surface, and all sub-pixels are equal in volume, a projection of any sub-pixel on the drive backplane does not coincide with a projection of any anode electrical connection structure on the drive backplane.

9. The pixel unit according to claim 8, wherein the second device layer further comprises at least one second conductive layer, and a projection of the second conductive layer on the drive backplane is greater than a projection of the second sub-pixel on the drive backplane; and
one side of any second conductive layer is connected to any second sub-pixel, and the other side is connected to a corresponding first bus layer.

10. The pixel unit according to claim 6, wherein when any one of the first sub-pixel, the second sub-pixel, and the third sub-pixel is a cuboid, any anode electrical connection structure in the first device layer is embedded in a corresponding first sub-pixel, and a projection, on the drive backplane, of any anode electrical connection structure in the first device layer is located within a projection of any third sub-pixel on the drive backplane.

11. The pixel unit according to claim 1, wherein any one of the first device layer, the second device layer, and the third device layer further comprises a color conversion layer disposed above any sub-pixel, and the color conversion layer absorbs an excitation light source emitted by a corresponding sub-pixel and converts the excitation light source into a target light source.

12. The pixel unit according to claim 1, wherein the display unit further comprises at least one reinforcement structure disposed on a periphery of any device layer.

13. A fabricating method for a pixel unit, wherein the fabricating method comprises:
preparing a drive backplane; and
fabricating a display unit, bonding a first target compound semiconductor to the drive backplane, and constructing at least one first sub-pixel to form a first device layer; bonding a second target compound semiconductor to the first device layer and constructing at least one second sub-pixel to form a second device layer; bonding a third target compound semiconductor to the second device layer and constructing at least one third sub-pixel to form a third device layer; and a projection of any first sub-pixel, any second sub-pixel, or any third sub-pixel on the drive backplane is located within a projection of any sub-pixel above the first sub-pixel, the second sub-pixel, or the third sub-pixel on the drive backplane; and
the first device layer emits red light in a working state, the second device layer emits green light in a working state, and the third device layer emits blue light in a working state.

14. A microdisplay, wherein the microdisplay comprises:
a microdisplay backplane, the microdisplay backplane comprising a drive circuit, an input interface, and an output interface;
a display area, the display area being disposed on the microdisplay backplane, the display area comprising at least two display units comprised in the pixel unit according to any one of claims 1 to 12, and the at least two display units being arranged in an array; and
a peripheral common cathode, the peripheral common cathode being electrically connected to each display unit.

15. A pixel-level discrete device, wherein the pixel-level discrete device comprises:
a discrete device backplane, the discrete device backplane comprising at least two anode pads and at least one cathode pad; and
a device body, the device body being disposed on the discrete device backplane, the device body comprising at least two display units comprised in the pixel unit according to any one of claims 1 to 12, and the at least two display units being arranged in an array.
